# FASCICULE DE BREVET EUROPEEN

(11) **EP 0 568 428 B1**
(45) Date de publication et mention de la délivrance du brevet: **16.07.1997**
(21) Numéro de dépôt: 93401060.4
(22) Date de dépôt: 23.04.1993
(51) Int. Cl.: H03K 17/08, H03K 17/10

(54) **Dispositif d'aide à la commutation pour composants interrupteurs de puissance montés en série dans un convertisseur d'énergie électrique alimenté en énergie électrique continue**
Entlastungsvorrichtung für in einem mit Gleichstrom gespeisten Leistungswandler seriengeschaltete Leistungsschalterbauteile
Snubber device for power switching components connected in series in an electric energy converter supplied with DC electric energy

(30) Priorité: 27.04.1992 FR 9205164
(43) Date de publication de la demande: 03.11.1993
(73) Titulaire: GEC ALSTHOM TRANSPORT SA, 75016 Paris (FR)
(72) Inventeur: Lanfranchi, Gilles, F-69330 Meyzieu (FR)
(74) Mandataire: Fournier, Michel

(56) Documents cités:
- EP-A- 0 270 940
- DE-A- 3 244 623
- IEEE TRANSACTIONS ON POWER ELECTRONICS vol. PE-2, no. 3, Juillet 1987, NEW YORK
- US pages 264 - 272 MCMURRAY 'Efficient snubbers for voltage-source GTO inverters'

## Description

La présente invention concerne un dispositif d'aide à la commutation pour composants interrupteurs de puissance montés en série dans un convertisseur d'énergie électrique alimenté par une source d'énergie électrique continue.

On rappelle qu'un dispositif d'aide à la commutation pour composants interrupteurs de puissance a pour but de réduire les pertes de commutation, c'est à dire d'éviter que le produit de la tension aux bornes de ces composants par le courant qui les traverse, au moment des opérations de commutation, n'atteigne des valeurs trop élevées.

On rappelle en outre qu'un dispositif d'aide à la commutation pour composant interrupteur de puissance commandable à l'ouverture et à la fermeture utilisé dans un convertisseur d'énergie électrique alimenté en énergie électrique continue comporte d'une manière générale :
- une inductance de limitation de vitesse de montée du courant dans ce composant, pendant les phases dites d'amorçage de ce composant (circuit de protection dit série),
- un condensateur de limitation de vitesse de montée de la tension aux bornes de ce composant, pendant les phases dites de blocage de ce composant (circuit de protection dit parallèle),
- un circuit de démagnétisation de ladite inductance de limitation, en dehors des phases d'amorçage de ce composant,
- un circuit de décharge dudit condensateur de limitation en dehors des phases de blocage de ce composant (circuit de protection dit parallèle).

Suivant les valeurs comparées de la tension maximale inverse que peut supporter un composant interrupteur de puissance, et de la tension aux bornes de la source d'alimentation en énergie électrique continue, il peut être nécessaire de disposer plusieurs composants interrupteurs de puissance en série.

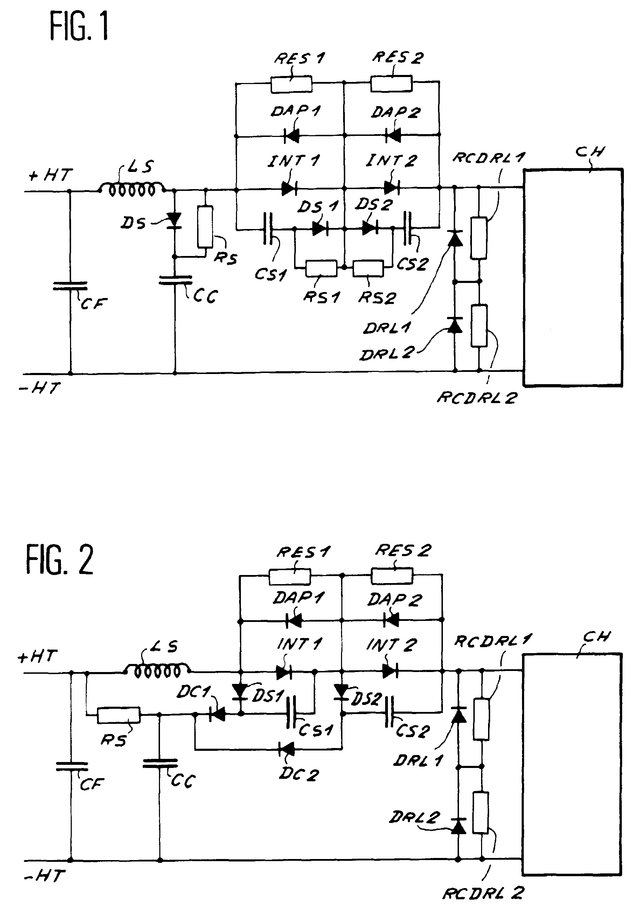

Un dispositif connu d'aide à la commutation pour deux composants interrupteurs de puissance montés en série dans un convertisseur d'énergie électrique constitué par un hacheur est rappelé sur la figure 1, où ces deux composants sont référencés respectivement INT1, INT2.

Dans ce dispositif, il est prévu une inductance de limitation, LS, commune à ces deux composants, et un condensateur de limitation pour chacun de ces composants, ces condensateurs étant notés respectivement CS1, CS2. Chacun de ces condensateurs de limitation est en outre monté en série avec un ensemble formé par une résistance (notée respectivement RS1, RS2) et une diode (notée respectivement DS1, DS2) montées en parallèle.

Les composants INT1 et INT2 considérés sont en l'occurence disposés entre le pôle positif, noté +HT, de la source de tension continue d'alimentation, et la charge, notée CH, et il est par ailleurs prévu, entre le point commun à l'inductance LS et aux composants INT1, INT2, et le pôle négatif - HT de la source de tension continue d'alimentation, un ensemble formé par une diode, DS, montée en parallèle avec une résistance, RS, l'ensemble formé par les éléments DS et RS étant en outre monté en série avec un condensateur noté CC.

Dans un dispositif d'aide à la commutation de ce type, l'inductance de limitation LS se démagnétise, pendant les phases de blocage, dans un circuit comportant la résistance RS et le condensateur CC, et les condensateurs de limitation CS1 et CS2 se déchargent, pendant les phases d'amorçage, dans des circuits comportant respectivement le composant INT1 et la résistance RS1, et le composant INT2 et la résistance RS2.
Un tel dispositif a pour inconvénient de ne pas limiter autant qu'il serait nécessaire la vitesse de montée du courant dans ces composants aux instants d'amorçage, la décharge des condensateurs de limitation CS1 et CS2 entraînant en effet un sur-courant dans ces composants à ces instants. Un tel dispositif a aussi pour inconvénient de ne pas permettre l'évacuation de l'énergie dite de commutation stockée dans l'inductance LS et dans les condensateurs CS1, CS2, dans un même dipôle d'évacuation de cette énergie.

Un circuit d'aide à la commutation permettant d'éviter ces inconvénients, et applicable à un convertisseur d'énergie électrique constitué par un bras d'onduleur et au cas d'un seul composant interrupteur de puissance, est décrit dans la demande de brevet allemand DE 3244 623 A1.

Dans ce dispositif, le condensateur de limitation est monté en série avec une diode, dite ici première diode, puis le point commun à cette première diode et à ce condensateur de limitation est raccordé par une diode dite ici deuxième diode, à l'une des bornes d'un dipôle dit d'évacuation d'énergie dont l'autre borne est à son tour raccordée à celle des bornes de l'inductance de limitation qui n'est pas connectée au composant interrupteur de puissance. Un autre condensateur est en outre prévu entre le point commun à la deuxième diode et au dipôle d'évacuation d'énergie, et celui des pôles de la source de tension continue d'alimentation auquel ledit composant n'est pas connecté par l'intermédiaire de l'inductance de limitation.

La présente invention a pour objet un dispositif d'aide à la commutation qui présente des avantages analogues à ceux de celui mentionné ci-dessus en dernier lieu, mais qui soit adapté au cas de composants interrupteurs de puissance montés en série.

La présente invention a pour objet un dispositif d'aide à la commutation pour composants interrupteurs de puissance montés en série dans un convertisseur d'énergie électrique alimenté d'une source d'alimentation en énergie électrique continu, essentiellement caractérisé en ce qu'il comporte :
- une inductance, dite de limitation, montée en série avec lesdits composants, pour limiter la vitesse de montée du courant dans ces composants pendant les phases dites d'amorçage de ces composants,
- un condensateur, dit de limitation, connectable en parallèle sur chacun desdits composants, pour limiter la vitesse de montée de la tension aux bornes de ce composant, pendant les phases dites de blocage, de ces composants,
- un dipôle d'évacuation d'energie électrique stockée dans ladite inductance de limitation et dans lesdits condensateurs de limitation,
- des moyens dits de branchement permettant d'une part la connexion des condensateurs de limitation aux bornes desdits composants pendant les phase de blocage, et d'autre part, pendant les phases de blocage la constitution d'un circuit dit de démagnétisation permettant d'évacuer l'énergie stockée dans ladite inductance de limitation, vers ledit dipôle d'évacuation d'énergie, et, pendant les phases d'amorçage, dans un premier temps la constitution de circuits dits de décharge permettant de transférer l'énergie stockée dans les condensateurs de limitation vers l'inductance de limitation, et dans un deuxième temps, la constitution d'un circuit de démagnétisation permettant d'évacuer l'énergie ainsi transférée dans l'inductance de limitation, vers le dipôle d'évacuation d'énergie,
- l'inductance et les au moins deux interrupteurs de puissance sont connectés en série entre un pôle (+HT) de la source d'alimentation et la charge (CH); et
- l'inductance et le dipôle d'évacuation sont connectés en série avec un condensateur (CC) entre les pôles de la source d'alimentation.

Suivant une autre caractéristique de l'invention, lesdits moyens de branchement comportent, pour chacun desdits composants, deux diodes dont l'une, dite première diode, permet la connexion du condensateur de limitation aux bornes du composant considéré pendant les phases de blocage, et dont l'autre, dite deuxième diode, permet, dans ledit premier temps des phases d'amorçage, la constitution d'un circuit de décharge pour le condensateur de limitation associé au composant considéré, la première et la deuxième diode associées à celui desdits composants qui se trouve directement connecté à l'inductance de limitation permettant, pendant les phases de blocage ainsi que pendant ledit deuxième temps des phases d'amorçage, la constitution dudit circuit de démagnétisation.

D'autres objets et caractéristiques de la présente invention apparaîtront à la lecture de la description suivante d'exemples de réalisation et d'application de la présente invention, faite en relation avec les dessins ci-annexés dans lesquels, outre la figure 1 décrite ci-dessus et relative à l'art antérieur :
- la figure 2 est un schéma d'un dispositif d'aide à la commutation suivant l'invention, adapté au cas de deux composants interrupteurs de puissance montés en série, dans une application à un convertisseur d'energie électrique constitué par un hacheur,
- la figure 3 illustre une variante pour le dispositif d'aide à la commutation représenté sur la figure 2,
- la figure 4 est un schéma d'un dispositif d'aide à la commutation suivant l'invention, adapté au cas de "n" composants interrupteurs de puissance montés en série dans une application à un convertisseur d'énergie électrique constitué par un hacheur,
- la figure 5 illustre une autre variante pour le dispositif d'aide à la commutation représenté sur la figure 2,
- la figure 6 illustre une variante pour le dispositif d'aide à la commutation représenté sur la figure 5,
- la figure 7 illustre l'application d'un dispositif d'aide à la commutation suivant l'invention, tel qu'illustré sur la figure 2 par exemple, à deux bras de hacheur,
- la figure 8 illustre l'application d'un dispositif d'aide à la commutation suivant l'invention, tel qu'illustré sur la figure 2 par exemple, à un schéma hacheur-abaisseur inversé,
- la figure 9 illustre l'application d'un dispositif d'aide à la commutation suivant l'invention, tel qu'illustré sur la figure 2 par exemple, à un schéma hacheur-élévateur,
- la figure 10 illustre l'application d'un dispositif d'aide à la commutation suivant l'invention, tel qu'illustré sur la figure 2 par exemple, à un bras d'onduleur de tension.

Le circuit d'aide à la commutation illustré sur la figure 2 est adapté au cas de deux composants interrupteurs de puissance, notés respectivement INT1, INT2, montés en série dans un convertisseur d'energie électrique qui est à titre d'exemple un hacheur-abaisseur.

Dans ce schéma, les composants INT1 et INT2 sont montés entre le pôle positif, noté +HT, de la source de tension continue d'alimentation, et la charge, notée CH. Ces composants sont à titre d'exemple symbolisés par des thyristors blocables par la gachette, dits aussi GTO (Gate-Turn off). L'invention est néanmoins applicable au cas de tout composant interrupteur de puissance pourvu qu'il soit amorçable et blocable.

Le circuit d'aide à la commutation illustré sur la figure 2 comporte :
- une inductance de limitation, notée LS, commune aux deux composants INT1 et INT2,
- un condensateur de limitation, noté CS1, associé au composant INT1,
- un condensateur de limitation, noté CS2, associé au composant INT2,
- une première et une deuxième diode associées au composant INT1, notées respectivement DS1 et DC1,
- une première et une deuxième diode associées au composant INT2, notées respectivement DS2 et DC2,
- un dipôle d'évacuation d'énergie de commutation, noté RS. A titre d'exemple ce dipôle d'évacuation d'énergie peut être constitué par une résistance; il pourrait aussi être constitué par un convertisseur continu-continu.

L'inductance de limitation LS est connectée entre le pôle positif + HT et l'anode du composant INT1.

La diode DS1 a son anode connectée au point commun à l'inductance de limitation LS et au composant INT1, et sa cathode connectée à l'une des bornes du condensateur de limitation CS1, l'autre borne du condensateur CS1 étant connectée à la cathode du composant INT1 et à l'anode du composant INT2.

La diode DS2 a son anode reliée à la cathode du composant INT1 et à l'anode du composant INT2, et sa cathode reliée à l'une des bornes du condensateur de limitation CS2, l'autre borne du condensateur de limitation CS2 étant connectée à la cathode du composant INT2.

La diode DC1 a son anode reliée au point commun à la diode DS1 et au condensateur de limitation CS1, et sa cathode reliée à l'une des bornes du dipôle d'évacuation d'energie RS, l'autre borne de ce dipôle étant connectée au pôle positif + HT de la source de tension continue d'alimentation.

La diode DC2 a son anode reliée au point commun à la diode DS2 et au condensateur de limitation CS2, et sa cathode reliée au point commun à la diode DC1 et du dipôle d'évacuation d'énergie RS.

Un autre condensateur, dit d'écrêtage, noté CC, est en outre connecté entre le point commun aux diodes DC1 et DC2 et au dipôle d'évacuation d'energie RS.

Ce schéma de hacheur inclut en outre, de façon classique, un condensateur dit de filtrage, CF, connecté entre les pôles positif + HT et négatif - HT de la source de tension continue d'alimentation, et deux diodes de roue-libre, notées DRL1 et DRL2, connectées en série au bornes de la charge CH.

Ce schéma de hacheur peut en outre inclure, de façon classique, une diode, telle que DAP1, DPA2, montée en antiparallèle respectivement sur chacun des composants INT1, INT2, et un circuit d'équilibrage, tel que RES1, RES2, monté en parallèle sur chacun de ces composants.

Il est en outre possible de monter en parallèle sur les diodes de roue libre des circuits de protection classiques, notés RCDRL1, RCDRL2.

Le fonctionnement du circuit d'aide à la commutation illustré sur la figure 2 comporte les étapes suivantes :
- à l'amorçage des composants INT1 et INT2 :
   a) échange de courant des diodes de roue libre vers les deux composants interrupteurs en série,
   b) au blocage des diodes de roue libre, un circuit du type LC série (avec L formé de l'inductance de limitation LS et C formé des condensateurs de limitation CS1 et CS2 en parallèle) se constitue et décharge les condensateurs de limitation CS1 et CS2 (les diodes DC1 et DC2 étant alors amorcées),
   c) au bout d'un quart de la période du circuit précédent, les condensateurs CS1 et CS2 sont déchargés. Dans le cas où le dipôle d'évacuation d'énergie est constitué par exemple par une résistance, un circuit du type RLC parallèle apparaît alors, avec L formé de l'inductance LS, C peu différent du condensateur CC (de capacité très supérieure à celle des condensateurs CS1 et CS2 en série) et R formé de la résistance d'évacuation d'énergie. L'inductance LS qui a reçu l'énergie stockée dans les condensateurs CS1 et CS2 transmet alors cette énergie à la résistance RS.
- au blocage :
   a) le courant Iₘ de chacun des composants interrupteurs est dévié vers le condensateur de limitation qui lui est associé; la vitesse de montée de la tension est limitée à Iₘ/CS si CS est la valeur de ce condensateur,
   b) Lorsque le potentiel du point A tend à dépasser la tension E de la source de tension continue d'alimentation, la diode DC1 s'amorce et l'inductance de limitation LS se démagnétise dans le circuit du type R, L, C déjà mentionné.

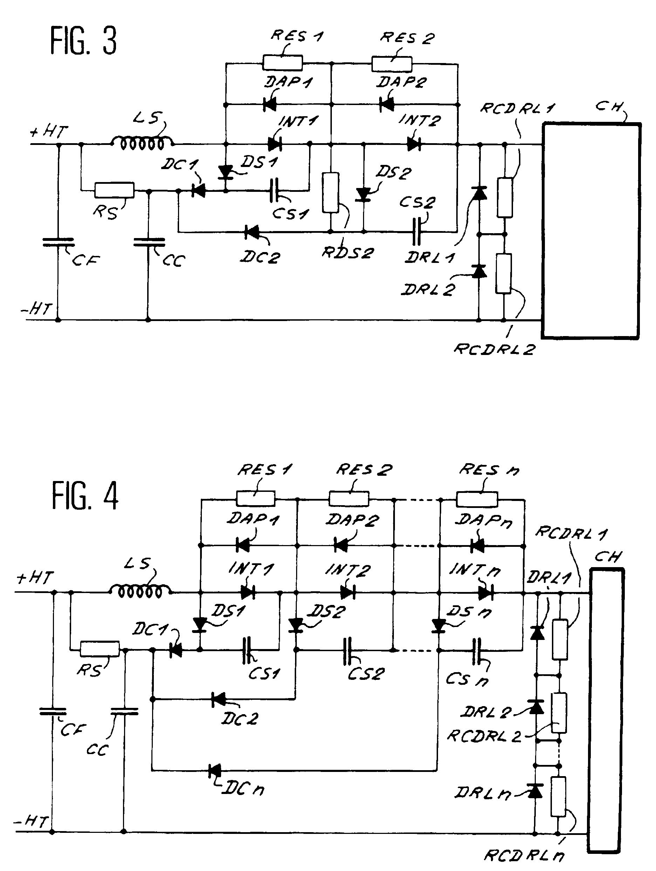

La figure 3 illustre une variante pour ce circuit d'aide à la commutation, consistant à placer une résistance, notée RDS2, en parallèle sur DS2.

Ceci a pour avantage d'autoriser une décharge lente des deux condensateurs CS1 et CS2 (en série) après un blocage, jusqu'à ce que la tension aux bornes des deux condensateurs en série rejoigne la valeur de la tension sur le condensateur de filtrage. On gagne alors sur le dimensionnement des condensateurs CS1 et CS2. La résistance RDS2 est bien sûr correctement dimensionnée pour que le courant qu'elle rajoute dans les composants interrupteurs à l'amorçage ait un effet négligeable sur les pertes à l'amorçage de ces composants.

Dans ce cas la dissipation d'énergie dans RDS2 est négligeable par rapport à la partie évacuée par le dipôle d'évacuation d'énergie RS. La récupération d'energie par RS reste intéressante et, dans le cas de l'installation du schéma dans une enceinte fermée, on peut ne sortir que les connexions vers RS.

Le principe exposé jusqu'ici pour le cas de deux composants interrupteurs est aisément extensible au cas de plus de deux composants interrupteurs en série.

La figure 4 illustre ainsi le cas de n composants INT1, INT2...INTn, qui sont également à titre d'exemple symbolisés par des thyristors GTO.

De même qu'un condensateur de limitation (CS1, CS2), ainsi qu'une première diode (DS1, DS2) et une deuxième diode (DC1, DC2), sont associés respectivement aux composants INT1 et INT2 de la figure 2, un condensateur de limitation, CSi, et une première et une deuxième diode, DSi, DCi, sont de même associés à chaque composant INTi (avec 2 <i≤ n), l'inductance de limitation LS et le dipôle d'évacuation d'énergie RS étant de même commun à l'ensemble des ces composants.

On notera que les diodes de roue-libre sont également en nombre égal à n, ces diodes étant notées DRL1, DRL2 ......DRLn.

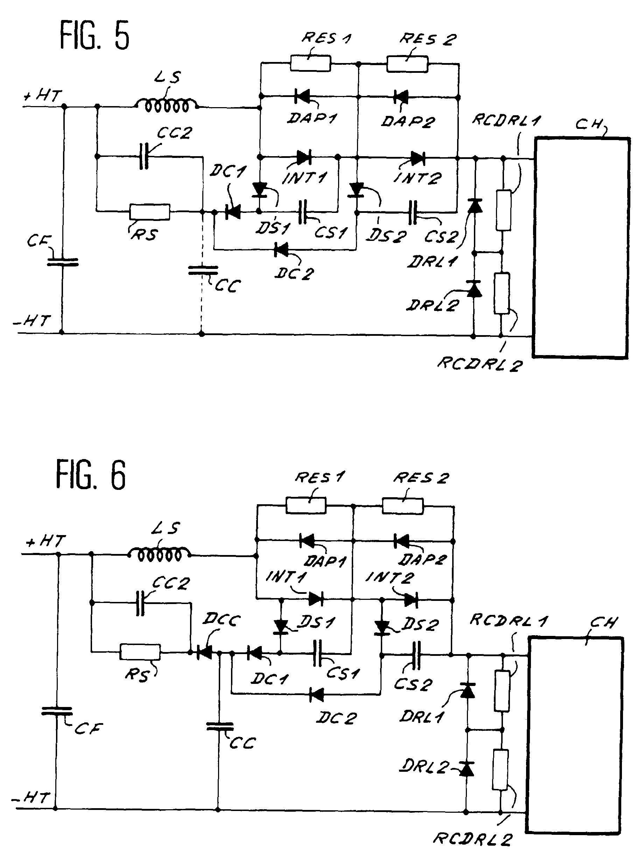

La figure 5 illustre une autre variante pour le dispositif d'aide à la commutation suivant l'invention, consistant en un découplage du condensateur CC par mise en parallèle avec le dipôle d'évacuation d'energie RS d'un condensateur noté CC2.

L'avantage de cette disposition réside dans le fait que le condensateur CC2 n'est dimensionné que pour tenir les surtensions liées aux commutations, alors que le condensateur CC est dimensionné pour la somme de la surtension maximale de commutation et de la valeur maximale de la tension filtrée.

Dans la mesure où les selfs de câblage vers le condensateur de filtrage l'autorisent, on peut se passer du condensateur CC (ce qui est symbolisé sur la figure par une représentation en pointillés) et réaliser ainsi un gain dans le dimensionnement du schéma.

La figure 6 illustre une variante pour le dispositif d'aide à la commutation représenté sur la figure 5. Suivant cette variante, une diode, notée DCC, est connectée entre le point commun aux diodes DC1 et DC2 (auquel elle est en l'occurence connectée par son anode) et le point commun au condensateur CC, au dipôle d'évacuation d'énergie RS, et au condensateur CC2 (auquel elle est en l'occurence connectée par sa cathode). Cette diode DCC permet de limiter les oscillations parasites dans le cas où les deux condensateurs, CC et CC2, sont utilisés.

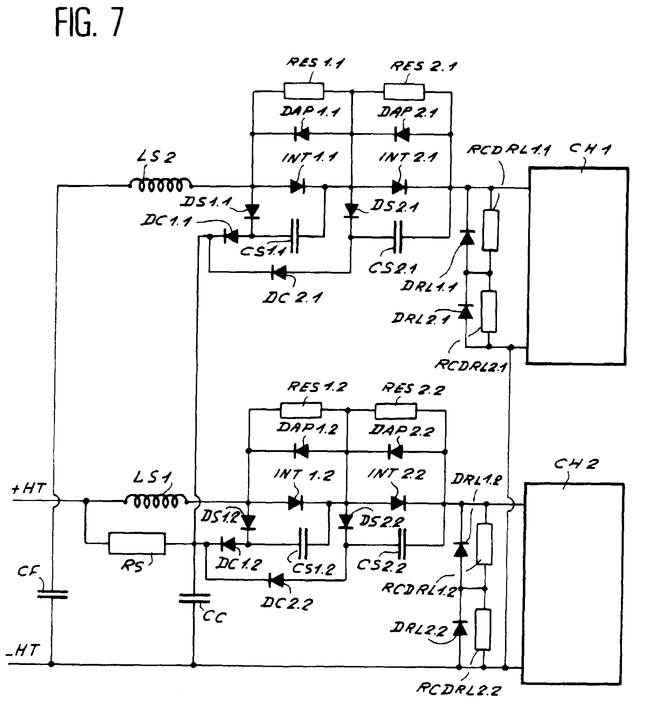

La figure 7 illustre l'application d'un dispositif tel qu'illustré sur la figure 2 par exemple, à deux bras de hacheurs connectés respectivement entre une source de tension continue d'alimentation commune, et deux charges distinctes notées respectivement CH1 et CH2. Chacun de ces bras est muni d'un tel dispositif, les éléments de ces bras et de ces dispositifs étant, sur la figure, affectés de l'indice 1 pour l'un de ces bras et de l'indice 2 pour l'autre bras, le dipôle d'évacuation d'energie RS et le condensateur CC étant en l'occurence communs aux deux bras.

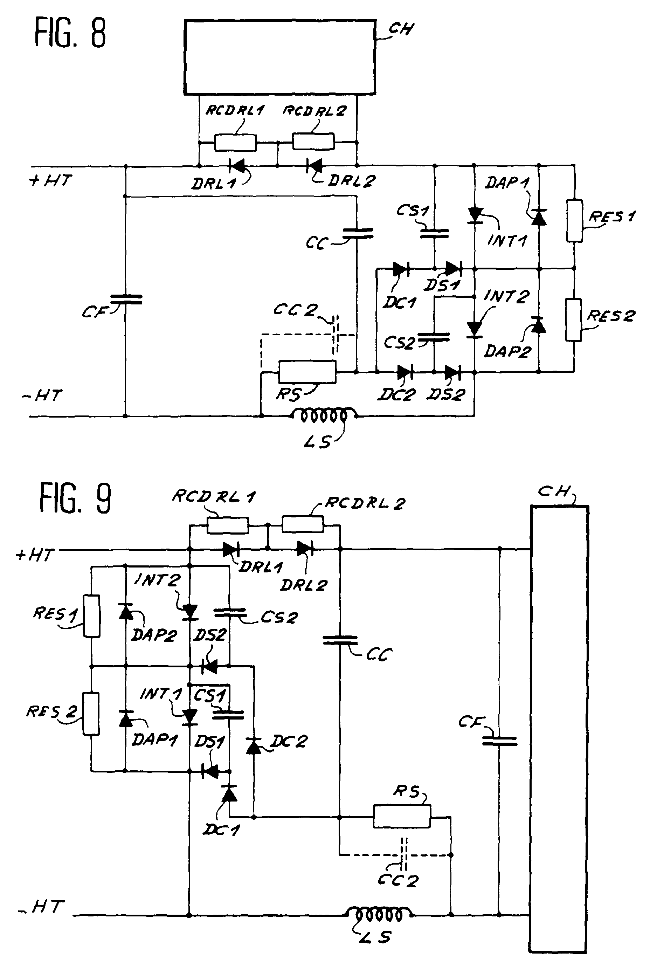

Les figures 8, 9 et 10 illustrent l'application d'un dispositif d'aide à la commutation suivant l'invention, tel qu'illustré sur la figure 2 par exemple, respectivement à un schéma hacheur-abaisseur inversé, à un schéma hacheur-élévateur, et à un bras d'onduleur de tension, tous de conception classique et par conséquent non redécrits ici.

On notera simplement que dans l'application à un bras d'onduleur de tension, deux ensembles de deux composants interrupteurs en série étant utilisés, les divers éléments formant ce schéma ont été affectés de l'indice 1 pour un de ces ensembles, et de l'indice 2 pour l'autre de ces ensembles.

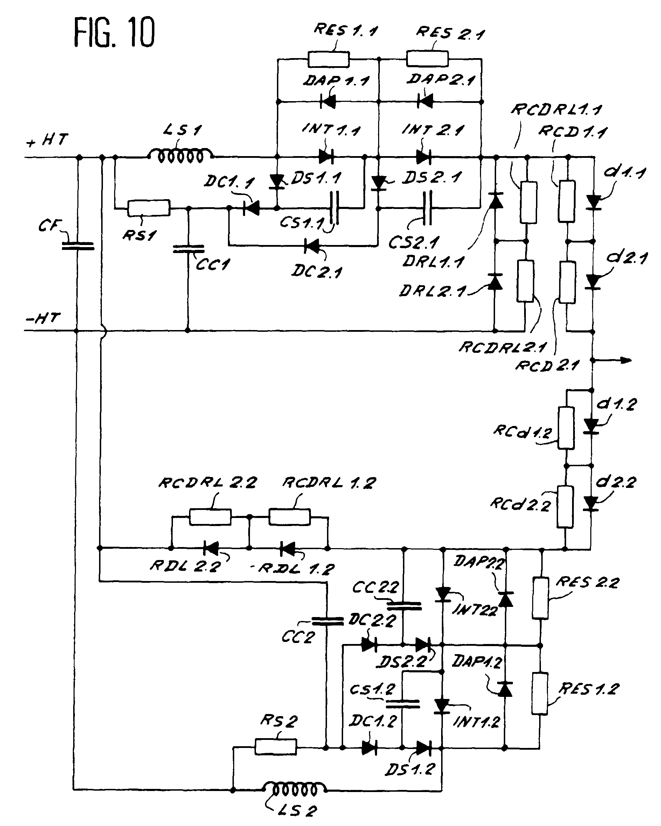

Le schéma de la figure 10 est en outre complété, de façon classique, par des diodes notées d1.1, d2.1, d1.2, d2.2 et par des circuits de protection associés, notés RCD1.1, RCD2.1, RCD1.2 et RCd2.2.

Bien que non illustrée spécifiquement sur les dessins, l'application d'un dispositif d'aide à la commutation suivant l'invention à un schéma hacheur-élévateur inversé serait aussi possible.

## Revendications

1. Dispositif d'aide à la commutation pour composants interrupteurs de puissance (INT1, INT2) montés en série dans un convertisseur d'energie électrique alimenté d'une source d'alimentation en énergie électrique continue, caractérisé en ce qu'il comporte :
- une inductance (LS), dite de limitation, montée en série avec lesdits composants, pour limiter la vitesse de montée du courant dans ces composants pendant les phases dites d'amorçage de ces composants,
- un condensateur (CS1, CS2), dit de limitation, connectable en parallèle sur chacun desdits composants, pour limiter la vitesse de montée de la tension aux cornes de ce composant, pendant les phases dites de blocage de ces composants,
- un dipôle (RS) d'évacuation d'energie électrique stockée dans ladite inductance de limitation et dans lesdits condensateurs de limitation,
- des moyens dits de branchement (DS1, DC1, DS2, DC2) permettant d'une part la connexion des condensateurs de limitation aux bornes desdits composants pendant les phases de blocage, et d'autre part, pendant les phases de blocage la constitution d'un circuit dit de démagnétisation permettant d'évacuer l'énergie stockée dans ladite inductance de limitation, vers ledit dipôle d'évacuation d'énergie, et, pendant les phases d'amorçage, dans un premier temps la constitution de circuits dits de décharge permettant de transférer l'énergie stockée dans les condensateurs de limitation vers l'inductance de limitation, et dans un deuxième temps, la constitution d'un circuit de démagnétisation permettant d'évacuer l'énergie ainsi transférée dans l'inductance de limitation, vers le dipôle d'évacuation d'énergie,
- l'inductance et les au moins deux interrupteurs de puissance sont connectés en série entre un pôle (+HT) de la source d'alimentation et la charge (CH); et
- l'inductance et le dipôle d'évacuation sont connectés en série avec un condensateur (CC) entre les pôles de la source d'alimentation.

2. Dispositif selon la revendication 1, caractérisé en ce que lesdits moyens de branchement comportent, pour chacun desdits composants, deux diodes dont l'une, dite première diode (DS1, DS2) permet la connexion du condensateur de limitation aux bornes du composant considéré pendant les phases de blocage, et dont l'autre, dite deuxième diode (DC1, DC2) permet, dans ledit premier temps des phases d'amorçage, la constitution d'un circuit de décharge pour le condensateur de limitation associé au composant considéré, la première et la deuxième diode associées à celui desdits composants qui se trouve directement connecté à l'inductance de limitation permettant, pendant les phases de blocage ainsi que pendant ledit deuxième temps des phases d'amorçage, la constitution dudit circuit de démagnétisation.

3. Dispositif selon la revendication 2, caractérisé en ce que :
- ladite première diode (DS1, DS2) à une électrode d'un premier type connectée, pour ce qui est de celui desdits composants qui se trouve directement connecté à l'inductance de limitation, au point commun à ce composant et à cette inductance, et pour ce qui est des autres composants, au point commun au composant considéré et à celui qui le précède dans le montage en série de ces composants,
- ladite première diode (DS1, DS2) a une électrode d'un deuxième type connectée au condensateur de limitation correspondant,
- ladite deuxième diode (DC1, DC2) a une électrode d'un premier type connectée à l'électrode d'un deuxième type de ladite première diode, et une électrode de deuxième type connectée à l'une des bornes du dipôle d'évacuation d'énergie, l'autre borne de de dipôle étant connectée à celle des bornes de l'inductance de limitation qui n'est pas raccordé au premier desdits composants de la mise en série.

4. Dispositif selon la revendication 3, caractérisé en ce qu'il comporte en outre une résistance (RDS2) montée en parallèle sur ladite première diode, pour les composants autres que celui connecté directement à ladite inductance de limitation.

5. Dispositif selon la revendication 3, caractérisé en ce que ledit condensateur (CC) est connecté entre le point commun auxdites deuxièmes diodes et au dipôle d'évacuation d'énergie, et celui des pôles de la source d'alimentation en énergie électrique continue qui n'est pas raccordé auxdits composants, par l'intermédiaire de l'inductance de limitation.

6. Dispositif selon l'une des revendications 1 à 5, caractérisé en ce qu'il comporte en outre un second condensateur (CC2) connecté en parallèle sur le dipôle d'évacution d'énergie (RS).

7. Dispositif selon les revendications 5 et 6, caractérisé en ce qu'il comporte en outre une diode (DCC) connectée entre le point commun auxdites deuxièmes diodes, et le point commun au dipôle d'évacuation d'énergie et au second condensateur (CC2) monté en parallèle sur ce dipôle d'évacuation d'énergie.

## Patentansprüche

1. Schalthilfsvorrichtung für Leistungsschaltbauteile (INT1, INT2), die in Reihe in einem von einer Gleichstrom-Speisequelle gespeisten Stromwandler angeordnet sind, dadurch gekennzeichnet, daß sie aufweist:
- eine Begrenzungsinduktanz (LS), die in Reihe mit den Leistungsschalt-Bauteilen angeordnet ist, um die Anstiegsgeschwindigkeit des Stroms in diesen Bauteilen während der Zündphasen dieser Bauteile zu begrenzen,
- einen Begrenzungskondensator (CS1, CS2), der parallel mit jedem dieser Bauteile verbunden werden kann, um die Anstiegsgeschwindigkeit der Spannung an den Klemmen dieses Bauteils während der Blockierphasen dieser Bauteile zu begrenzen,
- einen Dipol (RS) zur Abfuhr der in der Begrenzungsinduktanz und den Begrenzungskondensatoren gespeicherten elektrischen Energie,
- Anschlußmittel (DS1, DC1, DS2, DC2) einerseits zum Anschluß der Begrenzungskondensatoren an die Klemmen der Bauteile während der Blockierphasen und andererseits während der Blockierphasen zur Erzeugung einer Entmagnetisierungsschaltung, die es ermöglicht, die in der Begrenzungsinduktanz gespeicherte Energie zum Energieabfuhr-Dipol abzuführen, und während der Zündphasen zuerst zur Bildung von Entladeschaltungen, die die Übertragung der in den Begrenzungskondensatoren gespeicherten Energie zu der Begrenzungsinduktanz und dann zur Bildung einer Entmagnetisierungsschaltung, die die so in die Begrenzungsinduktanz übertragene Energie zum Energieabfuhr-Dipol übertragen kann,
- wobei die Induktanz und die mindestens zwei Leistungsschalter in Reihe zwischen einem Pol (+HT) der Speisequelle und der Last (CH) angeschlossen sind,
- und wobei die Induktanz und der Abfuhr-Dipol in Reihe mit einem Kondensator (CC) zwischen die Pole der Speisequelle angeschlossen sind.

2. Vorrichtung nach Anspruch 1, dadurch gekennzeichnet, daß die Anschlußmittel für jedes der Bauteile zwei Dioden enthalten, von denen die erste (DS1, DS2) den Anschluß des Begrenzungskondensators an die Klemmen des betrachteten Bauteils während der Blockierphase und die zweite (DC1, DC2) in den Zündphasen die Bildung einer Entladeschaltung für den dem betrachteten Bauteil zugeordneten Begrenzungskondensator erlaubt, wobei die erste und die zweite demjenigen Bauteil zugeordnete Diode, das direkt mit der Begrenzungsinduktanz verbunden ist, während der Blockierphasen und während des zweiten Teils der Zündphasen die Bildung der Entmagnetisierungsschaltung ermöglichen.

3. Vorrichtung nach Anspruch 2, dadurch gekennzeichnet, daß
- eine Elektrode eines ersten Typs der ersten Diode (DS1, DS2) für dasjenige Bauteil, das direkt mit der Begrenzungsinduktanz verbunden ist, mit dem gemeinsamen Punkt dieses Bauteils und dieser Induktanz, und für die anderen Bauteile mit dem dem betrachteten Bauteil und dem in der Reihenschaltung dieser Bauteile vorhergehenden Bauteil gemeinsamen Punkt verbunden ist,
- eine Elektrode eines zweiten Typs der ersten Diode (DS1, DS2) mit dem entsprechenden Begrenzungskondensator verbunden ist,
- eine Elektrode eines ersten Typs der zweiten Diode (DC1, DC2) mit der Elektrode eines zweiten Typs der ersten Diode verbunden ist und eine Elektrode des zweiten Typs mit einer der Klemmen des Energieabfuhr-Dipols verbunden ist, wobei die andere Klemme dieses Dipols mit derjenigen Klemme der Begrenzungsinduktanz verbunden ist, die nicht mit dem ersten der Bauteile der Reihenschaltung verbunden ist.

4. Vorrichtung nach Anspruch 3, dadurch gekennzeichnet, daß sie weiter einen Widerstand (RDS2) aufweist, der parallel zur erste Diode hinsichtlich der Bauteile montiert ist, die nicht direkt mit der Begrenzungsinduktanz verbunden sind.

5. Vorrichtung nach Anspruch 3, dadurch gekennzeichnet, daß der Kondensator (CC) zwischen dem den zweiten Dioden und dem Energieabfuhr-Dipol gemeinsamen Punkt und dem Pol der Gleichstrom-Speisequelle angeschlossen ist, der nicht mit den Bauteilen über die Begrenzungsinduktanz verbunden ist.

6. Vorrichtung nach einem der Ansprüche 1 bis 5, dadurch gekennzeichnet, daß sie weiter einen zweiten Kondensator (CC2) aufweist, der parallel zum Energieabfuhr-Dipol (RS) geschaltet ist.

7. Vorrichtung nach einem der Ansprüche 5 und 6, dadurch gekennzeichnet, daß sie weiter eine Diode (DCC) aufweist, die zwischen dem den zweiten Dioden gemeinsamen Punkt und dem dem Energieabfuhr-Dipol und dem parallel zum Energieabfuhr-Dipol liegenden zweiten Kondensator (CC2) gemeinsamen Punkt angeschlossen ist.

## Claims

1. A snubber circuit for power switch components (INT1, INT2) connected in series in an electrical energy converter fed by a DC source, said snubber circuit being characterized in that it comprises:
a "limiting" inductor (LS) connected in series with said components, for limiting the rate of the current rise in the components during "turn-on" stages when they are triggering;
a "limiting" capacitor (CS1, CS2) that can be connected in parallel with each of said components, for limiting the rate of the voltage rise across the terminals of the component, during "turn-off" stages when it is switching off;
an energy-dumping two-terminal network (RS) for dumping electrical energy stored in said limiting inductor and in said limiting capacitors; and
"connection" means (DS1, DC1, DS2, DC2) making it possible during the turn-off stages firstly to connect the limiting capacitors to the terminals of said components, and secondly to constitute a "demagnetization" circuit for dumping the energy stored in said limiting inductor to said energy-dumping two-terminal network, and making it possible during the turn-on stages initially to constitute "discharge" circuits for transferring the energy stored in the limiting capacitors to the limiting inductor, and then to constitute a demagnetization circuit for enabling the energy transferred in this way to the limiting inductor to be dumped to the energy-dumping two-terminal network;
the inductor and the at least two power switches being connected in series between a terminal (+HT) of the source and the load (CH); and
the inductor and the energy-dumping two-terminal network being connected in series with a capacitor (CC) between the terminals of the source.

2. A snubber circuit according to claim 1, characterized in that said connection means comprise two diodes for each of said components, namely a "first" diode (DS1, DS2) enabling the limiting capacitor to be connected to the terminals of the component in question during the turn-off stages, and a "second" diode (DC1, DC2) enabling a discharge circuit to be constituted for the limiting capacitor associated with the component in question during the initial portions of the turn-on stages, the first and second diodes associated with that one of said components which is directly connected to the limiting inductor enabling said demagnetization circuit to be constituted during the second portions of the turn-on stages.

3. A snubber circuit according to claim 2, characterized in that:
said first diode (DS1, DS2) has an electrode of a first type which, for the component that is directly connected to the limiting inductor, is connected to the point common to said component and to said inductor, and, for the other components, is connected to the point common to the component in question and to the preceding component in the set of components in series;
said first diode (DS1, DS2 has an electrode of a second type connected to the corresponding limiting capacitor;
said second diode (DC1, DC2) has an electrode of a first type connected to the electrode of the second type of said first diode, and an electrode of a second type connected to one of the terminals of the energy-dumping two-terminal network, the other terminal of the two-terminal network being connected to that one of the terminals of the limiting inductor which is not connected to the first of said components in the series set.

4. A snubber circuit according to claim 3, characterized in that it further includes a resistor (RDS2) connected in parallel with said first diode, for components other than the component connected directly to said limiting inductor.

5. A snubber circuit according to claim 3, characterized in that said capacitor (CC) is connected between the point common to said second diodes and to the energy-dumping two-terminal network, and that one of the terminals of the DC source which is not connected to said components, via the limiting inductor.

6. A snubber circuit according to any one of claims 1 to 5, characterized in that it further includes a second capacitor (CC2) connected in parallel with the energy-dumping two-terminal network (RS).

7. A snubber circuit according to claims 5 and 6, characterized in that it further includes a diode (DCC) connected between the point common to said second diodes, and the point common to the energy-dumping two-terminal network and to the second capacitor (CC2) connected in parallel with the energy-dumping two-terminal network.
